# EUROPEAN PATENT APPLICATION

(11) **EP 4 686 771 A2**
(43) Date of publication of application: **04.02.2026**
(21) Application number: 25192941.0
(22) Date of filing: 30.07.2025
(51) Int. Cl.: C23C 16/26, C23C 16/455

(54) **METHODS FOR DEPOSITING CONDUCTIVE CARBON FILMS**

(30) Priority: 30.07.2024 US 202463677215 P; 21.07.2025 US 202519275743
(71) Applicant: Micron Technology, Inc., Boise, ID 83716-9632 (US)
(72) Inventor: LEHN, Jean-Sebastien Materne, Boise, 83716-9632 (US)
(74) Representative: Marks & Clerk LLP

(57) **Abstract**

Methods, systems, and devices for depositing carbon conducting films are described. The method may include reacting a first precursor with a base material to form a carbon compound on a material. The first precursor may include at least one of germanium, silicon, or tin. The method may further include reacting a second, carbon-containing precursor with the carbon compound to form a layer on the base material. In such cases, a layer of carbon on a plurality of stacks of materials may be formed by exposing the plurality of stacks of materials to the first precursor and the second, carbon-containing precursor.

## Description

### FIELD OF TECHNOLOGY

The following relates to methods for performing atomic layer deposition, including methods for depositing carbon conducting films.

### BACKGROUND

Atomic layer deposition (ALD) is a technique used to deposit a film on a first material. For instance, performing ALD may include exposing the first material to a first precursor to form a second material on the first material. Additionally, performing ALD may include exposing the second material to a second precursor, where the second precursor may react with the second material to leave a third material on the surface of the first material. In some examples, the process may repeat, where the third material may be exposed to the first precursor to form another instance of the second material on the third material, and then the other instance of the second material may be exposed to the second precursor to leave another instance of the third material on the surface of the previously formed instance of the third material.

In some examples, reactions involved in ALD may occur at various temperatures. However, if such temperatures are outside of a predefined range for a threshold duration, other materials in a vicinity to the material being exposed to ALD may experience a change in physical or chemical properties beyond an expected threshold. Such changes in physical or chemical properties may adversely affect an operation of an electronic device that includes these other materials (e.g., may decrease a lifetime of the electronic device, may increase a likelihood that the electronic device displays errant behavior or does not perform its intended function). For some materials, the temperature in order to facilitate reactions (e.g., for forming the third material) in ALD may exceed the predefined range for the threshold duration. Accordingly, materials whose reactions may be facilitated to be within the predefined range or to be outside of the predefined range for less than the predefined duration, may decrease a likelihood that the operation of the electronic device is adversely affected.

### BRIEF DESCRIPTION OF THE DRAWINGS

FIG. 1 illustrates an example of an atomic layer deposition (ALD) process that supports methods for depositing carbon conducting films in accordance with examples as disclosed herein.
FIG. 2 illustrates an example of a material formation process that supports methods for depositing carbon conducting films in accordance with examples as disclosed herein.
FIG. 3 illustrates an example of an electronic device that supports methods for depositing carbon conducting films in accordance with examples as disclosed herein.
FIGs. 4 and 5 show flowcharts illustrating a method or methods that support methods for depositing carbon conducting films in accordance with examples as disclosed herein.
FIG. 6 shows an example of a memory array that supports methods for depositing carbon conducting films in accordance with examples as disclosed herein.
FIG. 7 shows a top view of an example of a memory array that supports methods for depositing carbon conducting films in accordance with examples as disclosed herein.
FIGs. 8A and 8B show side views of an example of a memory array that supports methods for depositing carbon conducting films in accordance with examples as disclosed herein.

### DETAILED DESCRIPTION

An electronic device may be made up of layers of materials. One technique for adding layers to the electronic device is to perform atomic layer deposition (ALD). In some examples, it may be advantageous for one or more of those layers to be made up of carbon with a purity above a threshold amount (e.g., 85% pure carbon, 90% pure carbon, 95% pure carbon, 99% pure carbon, 99.9% pure carbon). For instance, carbon with the purity above the threshold amount may have conductive properties that may enhance the operation of the electronic device (e.g., such carbon may have a higher conductivity as compared to other materials). However, previously disclosed precursors used in ALD have not been shown to be capable of producing such carbon. Instead, these previously disclosed precursors deposit other elements or compounds with the carbon. In some cases, previously disclosed precursors including an acetylene, a diacetylene, a tri-acetylene, a polyacetylene, an alkene, or an arene may result in a deposition film with higher resistivity, higher contamination, decreased thickness, or a combination thereof.

The techniques disclosed herein describe precursors capable of being used in ALD to produce one or more layers of carbon with the purity above the threshold amount for an electronic device. For instance, the techniques may include exposing a material (e.g., a base material) to a first precursor and reacting the first precursor with the material to form a first carbon compound, where the first precursor may include at least one of germanium, silicon, or tin. Additionally, the techniques may include reacting a second, carbon-containing precursor with the carbon compound to form a layer of carbon on the material.

Additionally, or alternatively, the precursors disclosed herein may enable lower temperatures to be used for forming a layer of carbon on a material. For instance, the reactivity of germanium, silicon, or tin may be such that the layer of carbon can be formed at a lower temperature when reacting the second, carbon-containing precursor with the carbon compound, as the carbon compound may include the germanium, silicon, or tin. Additionally, or alternatively, in some examples, the reactivity of germanium and tin may be higher than that of silicon such that the layer of carbon may be formed at lower temperatures using germanium or tin in the first precursor as compared to examples of the first precursor that do not contain the germanium or the tin. In some cases, the precursors disclosed herein may omit including an acetylene, a diacetylene, a tri-acetylene, a polyacetylene, an alkene, or an arene, thereby resulting in depositing the carbon conducting film with lower resistivity, lower contamination, increased thickness, or a combination thereof as compared with reacting the base material with a precursor including an acetylene, a diacetylene, a tri-acetylene, a polyacetylene, an alkene, or an arene.

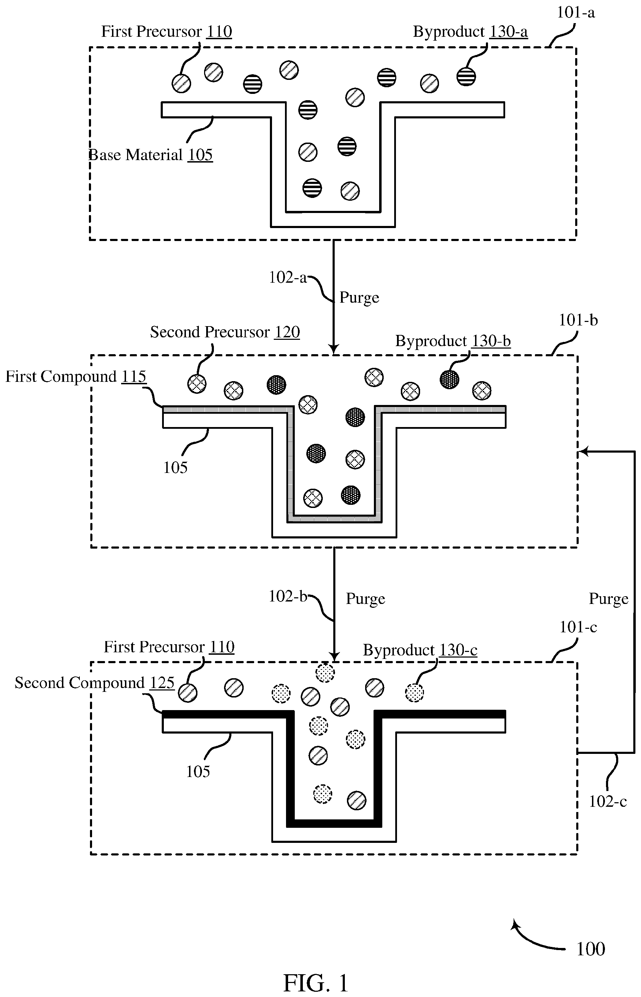

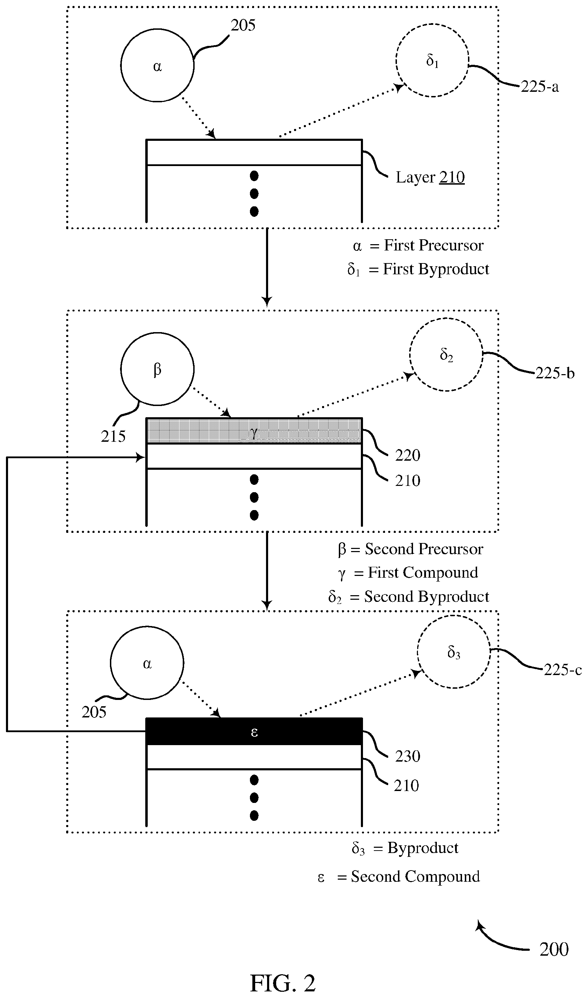

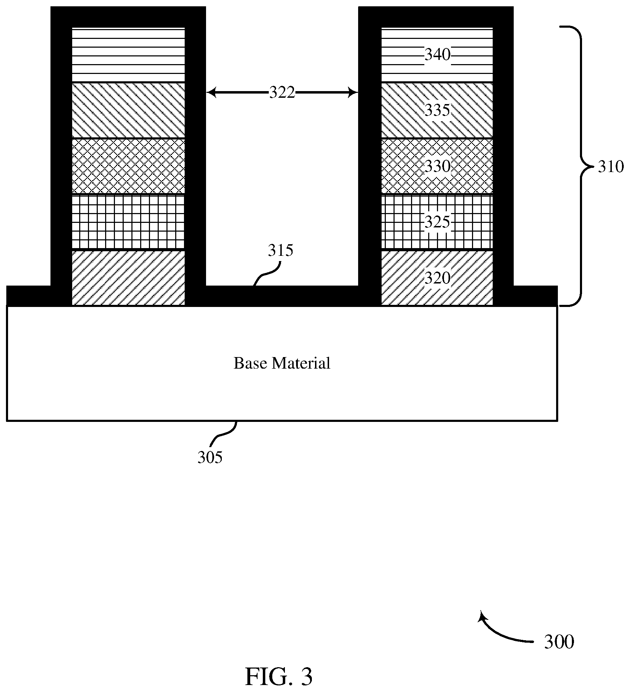

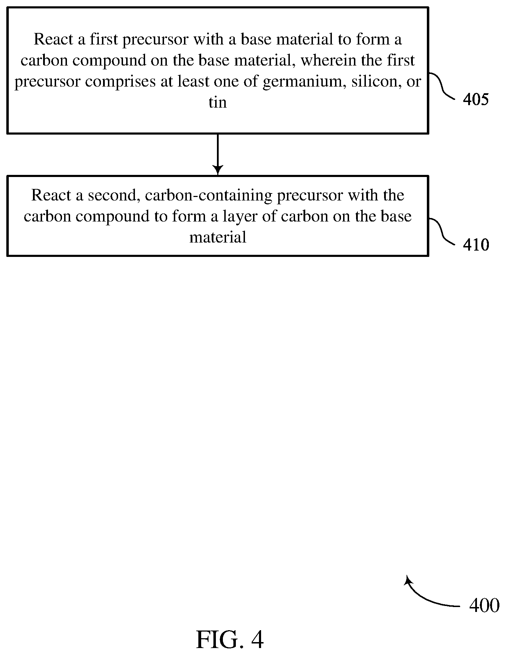

Features of the disclosure are initially described in the context of an ALD process and a material formation process as described with reference to FIGs. 1 and 2. Features of the disclosure are described in the context of an electronic device as described with reference to FIG. 3. These and other features of the disclosure are further illustrated by and described with reference to an apparatus diagram and flowcharts that relate to methods for depositing carbon conducting films by atomic layer deposition as described with reference to FIGs. 4 through 6.

**FIG. 1** illustrates examples of an ALD process 100 that supports methods for depositing carbon conducting films in accordance with examples as disclosed herein.

As illustrated in stage 101-a, a base material 105 may be exposed to a first precursor 110. For instance, the base material 105 may be located in a reactor (e.g., deposition chamber) within which a gaseous phase of the first precursor 110 may be introduced. Exposing the base material to the first precursor 110 may enable a first compound 115 to form on the surface of the base material 105, as depicted in stage 101-b. For example, the first precursor 110 may be introduced in three rounds of ten second doses for each round. In such cases, the first precursor 110 may introduced for ten seconds in a first round, another ten seconds in a second round, and a final ten seconds in a third round. After the final ten second round, or each ten second dose, sixty seconds of time elapses before removing the byproduct 130-a and/or at least a portion of the first precursor 110 from the reactor (e.g., performing a purge). In such cases, the first precursor 110 may be purged after sixty seconds.

In some examples, as a result of the reaction between base material 105 and first precursor 110, a byproduct 130-a will be formed. After forming first compound 115, a byproduct 130-a may be formed; in that case, the byproduct 130-a and/or a portion of the first precursor 110 may be purged (e.g., removed from the reactor) at 102-a before proceeding to stage 101-b. For example, the byproduct 130-a and/or a portion of the first precursor 110 may be purged for two seconds. In some cases, the purge may after the sixty seconds elapses after performing the three rounds. In such cases, the byproduct 130-a and/or a portion of the first precursor 110 may be purged for two seconds after the three doses (e.g., rounds) of the first precursor was introduced. In some examples, the temperature of the reactor may be set or adjusted to a first predefined value such that the first compound 115 forms on the surface of the base material 105. For example, the temperature of the reactor may be set to 288°C.

In some examples, the base material may be a substrate. In some examples, exposing a material to a precursor may refer to adding the precursor to the reactor within which the material is located, whereas reacting the material with the precursor may refer to a chemical reaction that occurs between the precursor and the material and may involve setting or adjusting a temperature of the reactor to a particular temperature that facilitates the reaction.

After forming the first compound 115 at stage 101-a, the first compound 115 may be exposed to a second precursor 120 at stage 101-b. For instance, a gaseous phase of the second precursor 120 may be introduced into the reactor and exposed to the surface of the first compound 115. In some examples, the base material 105 may be transported to a second reactor for introducing the second precursor 120. In other examples, the same reactor may be used. The second precursor 120 may react with the first compound 115 to form a second compound 125, as shown in stage 101-b. For example, the second precursor 120 may be introduced in a single round of a twenty second dose (e.g., soak). After the twenty second soak occurs, sixty seconds of time elapses before removing the byproduct 130-b and/or at least a portion of the second precursor 120 from the reactor (e.g., performing a purge). In such cases, the second precursor 120 may be purged after sixty seconds.

In some examples, as a result of the reaction between first compound 115 and second precursor 120, a byproduct 130-b will be formed. After forming second compound 125, the byproduct 130-b and/or at least a portion of the second precursor 120 may be purged (e.g., removed from the reactor) at 102-b before proceeding to stage 101-c. For example, the byproduct 130-b and/or at least a portion of the second precursor 120 may be purged for two seconds. In some examples, the temperature of the reactor may be set or adjusted to a second predefined value such that the second compound 125 forms on the surface of the base material 105. For example, the temperature of the reactor may be set to 288°C.

After forming the second compound 125 at stage 101-b, the second compound 125 may be exposed to a first precursor 110 at stage 101-c. For instance, a gaseous phase of the first precursor 110 may be introduced to the reactor and exposed to the surface of the second compound 125. In some examples, the base material 105 may be transported to a third reactor for introducing the first precursor 110. In other examples, the same reactor may be used for stage 101-c as used for one or both of stages 101-a and 101-b. The first precursor 110 may react with the second compound 125 to form a second instance of the first compound 115 on top of the second compound 125. In some examples, as a result of the reaction between second compound 125 and first precursor 110, a byproduct 130-c will be formed. After forming the second instance of first compound 115, the byproduct 130-c and/or at least a portion of the first precursor 110 may be purged (e.g., removed from the reactor) at 102-c before returning back to stage 101-b. In some examples, the temperature of the reactor may be set or adjusted to the first predefined value or a third predefined value such that the first compound 115 forms on the surface of the base material 105. In some examples, first precursor 110 and second precursor 120 may be delivered to the reactor (e.g., or reactors) using an inert gas (e.g., argon, helium, nitrogen). Additionally, or alternatively, the byproducts 130-a, 130-b and/or 130-c may be purged using an inert gas (e.g., argon, helium, nitrogen).

In some examples, the process may be repeated to deposit multiple layers of the second compound 125. For instance, after depositing a first instance of second compound 125, the first instance of the second compound 125 may be exposed to the first precursor 110 to form a second instance of the first compound 115 on a surface of the first instance of the second compound 125. Then, the second instance of the first compound 115 may be exposed to the second precursor 120 to form a second instance of the second compound 125 on the surface of the first instance of the second compound 125.

In some examples, the first precursor 110 may include at least one of germanium, silicon, or tin. In some cases, the first precursor 110 may include at least one of germanium, silicon, tin, lead, or any Group 14 element. Additionally, or alternatively, the second precursor 120 may be carbon-containing. Using these precursors, a layer of carbon (e.g., carbon with above 85% purity, carbon with above 90% purity, carbon with above 95% purity, carbon with above 99% purity, carbon with above 99.9% purity) may be deposited as the second compound 125.

It should be noted that there may be examples in which the second precursor 120 may react with the base material 105 to form a third compound. In some such examples, the first precursor 110 may react with the third compound to form a fourth compound. The process may be repeated and such that multiple layers of carbon (e.g., carbon with above 85% purity, carbon with above 90% purity, carbon with above 95% purity, carbon with above 99% purity, carbon with above 99.9% purity) may form.

In some examples, the base material 105 may be a structure on a substrate (e.g., a wafer). In some such examples, the base material 105 may span in a first direction and a second direction, where the first direction is orthogonal to the second direction. Additionally, a memory device including the base material 105 may include word lines extending along the first direction and/or the second direction and bit lines extending along a third direction orthogonal to the first direction and the second direction. In some such examples, a stack of materials (e.g., a sequence of materials) may be formed in one or more recesses of the word lines, where the stack may extend along the first direction and/or the second direction and where the sequence of materials may include a memory cell (e.g., a chalcogenide element). In some examples, the techniques described herein may be used to form layers of carbon on the base material 105, the word lines, the bit lines, the stacks, or any combination thereof.

**FIG. 2** illustrates an example of a material formation process 200 that supports methods for depositing carbon conducting films in accordance with examples as disclosed herein.

As illustrated in FIG. 2, a layer 210 may be exposed to a first precursor 205. The first precursor, for instance, may include at least one of germanium, silicon, or tin. In some cases, the first precursor 110 may include at least one of germanium, silicon, tin, lead, or any Group 14 element. In some examples, the first precursor 205 reacting with the layer 210 may form a byproduct 225-a, which may be removed from the reactor. After forming the first compound 220, the first compound 220 may be exposed to a second precursor 215, where the second precursor may contain carbon. The second precursor 215 may react with the first compound 220 to form second compound 230, which may be a layer of carbon (e.g., carbon with above 85% purity, carbon with above 90% purity, carbon with above 95% purity, carbon with above 99% purity, carbon with above 99.9% purity). In some examples, the second precursor 215 may form a layer on the first compound 220 and the layer may react with the first compound 220 to form the second compound 230. In other examples, the second precursor 215 may directly react with the first compound 220 to form the second compound 230. This reaction may produce a byproduct 225-b, which may be removed from the reactor.

In some examples, the second compound 230 may be exposed to a first precursor 205 to form a second instance of the first compound on the second compound 230. In some examples, the first precursor may form a layer on the second compound 230 and the layer may react with the second compound 230 to form the second instance of the first compound. In other examples, the first precursor 205 may directly react with the second compound 230 to form the second instance of the first compound. This reaction may produce a byproduct 225-c, which may be removed from the reactor. Without deviating from the scope of the disclosure, the second instance of the first compound may instead be a third compound distinct from the first compound. In some examples, the process may be repeated to deposit multiple layers of the second compound 230. For instance, the process may repeat again where the second instance of the first compound acts as depicted first compound 220 and second compound 230 acts as layer 210. In some examples, first precursor 205 and second precursor 215 may be delivered to the reactor (e.g., or reactors) using an inert gas (e.g., argon, helium, nitrogen). Additionally, or alternatively, the byproducts 225-a, 225-b, and/or 225-c may be purged using an inert gas (e.g., argon, helium, nitrogen).

In a first example, the first compound 220 may include -Sub-(-SiMe₃)ₙ bonded with a substrate and the second precursor 215 may include n molecules of CBr₄, where n may be 2 or 3, for instance, although n may also have other values. Additionally, Sub may represent the substrate, Si may represent silicon, Me may represent methyl, C may represent carbon, and Br may represent bromine. In such examples, the first compound 220 and the second precursor 215 may react to form a second compound 230 that includes the substrate and -Sub-(-SiMe₃)ₙ and will also form a byproduct 225-b that includes n moles of Br-SiMe₃. For instance, CBr₃ may replace the SiMe₃ of the first compound 220. Additionally, first precursor 205 may be Me₃Si-SiMe₃ and may react with the CBrₙ (e.g., CBr₃) of the second compound 230. In such examples, the SiMe₃ of the first precursor 205 may replace the Br of the -Sub-(-CBr₃)ₙ to form an additional layer of carbon (e.g., - Sub-(- -C-{-SiMe₃}₃)ₙ bonded with the substrate may be formed). Additionally, the byproduct 225-c will be produced and may have the chemical formula Br-SiMe₃. Other byproducts 225-b and 225-c (e.g., {MeO-SiMe₃}, {Me₂N-SiMe₃}, {Br-GeMe₃}, {Br-SnMe₃}, {Br-SiEt₃}, {Cl-SiMe₂-SiMe₃}) may be obtained by using other compounds.

In some examples, the first precursor 205 may be defined as the chemical formula R₁R₂R₃A-ZR₄R₅R₆, where A or Z are independently selected from germanium, tin, or silicon. In some cases, A or Z are independently selected from germanium, tin, silicon, lead, or any Group 14 element. In some examples, the first precursor 205 may be defined as the chemical formula R₁R₂R₃A-ZR₄R₅R₆, where each of R₁, R₂, R₃, R₄, R₅, and R₆ are independently selected from hydrogen (or deuterium), an alkyl group, an aryl group, an alkoxy, a di-alkylamide, an amide with an alkyl and a silyl substituent (e.g., the silyl group has hydrogen, deuterium or alkyl substituents), an amide with two silyl substituents (e.g., the silyl groups have hydrogen, deuterium or alkyl substituents), an amide with an alkyl and a germyl substituent (e.g., the germyl group has hydrogen, deuterium or alkyl substituents), a tri-alkylhydrazide, a hydrazide with a combination of three substituents which can be alkyl, silyl, or germyl (e.g., the silyl group and the germyl group have hydrogen, deuterium or alkyl substituents), an alkyl-sulfide, an alkyl-selenide, a halide, or an alkyl-telluride. Additionally, or alternatively, each of R₁, R₂, R₃, R₄, R₅, and R₆ may be independently selected from a cyanide, an isocyanide, a cyanate, an isocyanate, a thiocyanate, an isothiocyanate, a selenocyanate, an isoselenocyanate, a tellurocyanate, an isotellurocyanate, an azide, a fulminate, or an isofulminate. Additionally, or alternatively, each of R₁, R₂, R₃, R₄, R₅, and R₆ may be independently selected from a -SiRₐR_{b}R_{c} moiety, a -GeRₐR_{b}R_{c} moiety, a -SnRₐR_{b}R_{c} moiety, a -SiRₐR_{b}CR_{c}R_{d}Rₑ moiety, a -CRₐR_{b}SiR_{c}R_{d}Rₑ moiety, a -SiRₐR_{b}GeR_{c}R_{d}Rₑ moiety, or more generally a moiety containing a set of carbon atoms, silicon atoms, germanium atoms, tin atoms, or any combination thereof. For instance, each atom of the set of carbon atoms, silicon atoms, germanium atoms, tin atoms, or any combination thereof is fully saturated with respective substituents so that each of these (carbon, silicon, germanium, or tin) atoms has 4 bonds, which can either be to other (carbon, silicon, germanium, or tin) atoms of the set or to corresponding substituents represented as Rₐ through Rₓ (where the substituents may be indexed as *a,b,c .* . *.,x*, where *x* is some index different than *a*)*.* In some such examples, up to 10 atoms of carbon, silicon, germanium, or tin may be included in the set that are distinct from any atoms of carbon, silicon, germanium, or tin of the Rₐ through Rₓ substituents. Additionally, the set of carbon atoms, silicon atoms, germanium atoms, tin atoms, or any combination thereof may be linear, branched, or cyclic. In some examples, Rₐ through Rₓ may be independently selected from hydrogen (or deuterium), an alkyl group, an aryl group, an alkoxy, a di-alkylamide, an amide with an alkyl and a silyl substituent or group (e.g., the silyl group has hydrogen, deuterium or alkyl substituents), an amide with two silyl substituents or groups (e.g., the silyl groups have hydrogen, deuterium or alkyl substituents), an amide with an alkyl and a germyl substituent or group (e.g., the germyl group has hydrogen, deuterium or alkyl substituents), a tri-alkylhydrazide, a hydrazide with a combination of three substituents or groups which can be alkyl, silyl, or germyl (e.g., the silyl group and the germyl group have hydrogen, deuterium or alkyl substituents), an alkyl-sulfide, an alkyl-selenide, a halide, an alkyl-telluride, a cyanide, an isocyanide, a cyanate, an isocyanate, a thiocyanate, an isothiocyanate, a selenocyanate, an isoselenocyanate, a tellurocyanate, an isotellurocyanate, an azide, a fulminate, or an isofulminate. In some examples, the first precursor 205 as described herein may have the following form:

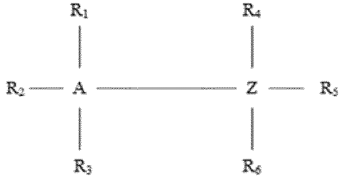

In some examples, the second, carbon-containing precursor 215 may be defined as chemical formula CX₁X₂X₃X₄, where each of X₁, X₂, X₃, and X₄ are bromide. In some examples, the second, carbon-containing precursor 215 may be defined as chemical formula CX₁X₂X₃X₄, or W₁=CX₃X₄, or W₁=C=W₂, or NCX₃, where each of X₁, X₂, X₃, and X₄ are independently selected from fluoride, chloride, bromide, iodide, cyanide, a methoxy, an ethoxy, an alkoxy, an alkyl-sulfide, an alkyl-selenide, an alkyl-telluride, a cyanide, an isocyanide, a cyanate, an isocyanate, a thiocyanate, an isothiocyanate, a selenocyanate, an isoselenocyanate, a tellurocyanate, an isotellurocyanate, an azide, a fulminate, or an isofulminate, a dimethylamide, a diethylamide, an ethylmethylamide, a di-alkylamide, an amide with an alkyl and a silyl substituent (e.g., the silyl group has hydrogen, deuterium or alkyl substituents), an amide with two silyl substituents (e.g., the silyl groups have hydrogen, deuterium or alkyl substituents), an amide with an alkyl and a germyl substituent (e.g., the germyl group has hydrogen, deuterium or alkyl substituents), a tri-alkylhydrazide, a hydrazide with a combination of three substituents which can be alkyl, silyl, or germyl (e.g., the silyl group and the germyl group have hydrogen, deuterium or alkyl substituents), hydrogen (or deuterium) or an alkyl, or an aryl, or an alkyl containing double or triple carbon-carbon bonds, or any combination thereof. Additionally, W₁ and W₂ are independently selected from oxygen, sulfur, selenium, or tellurium; examples of molecules containing W₁ and W₂ can be O=CCl₂, O=C=S, or S=C=S. N is nitrogen; examples of molecules containing N can be NCBr, cyanogen bromide. In some examples, the second, carbon-containing precursor 215 may be a tetramethylorthocarbonate (e.g., C(OMe)₄, where Me is a methyl), a tetraethylorthocarbonate (e.g., C(OEt)₄, where Et is an ethyl), a tetrakis(dimethylamino)methane (e.g., C(NMe₂)₄,) a tetrakis(diethylamino)methane (e.g., C(NEt₂)₄,), or a tetrakis(ethylmethylamino)methane (e.g., C(NMeEt)₄,). In cases where the second, carbon containing precursor contains an atom Wₙ (n=1 or 2), the byproduct 225-b will be Me₃Si-Wₙ-SiMe₃, for example hexamethyldisiloxane, Me₃Si-O-SiMe₃. In cases the second, carbon containing precursor contains an atom N the byproduct 225-b will be N(SiMe₃)₃, tris(trimethylsilyl)amine. In some examples, the second, carbon-containing precursor 215 may have the following form:

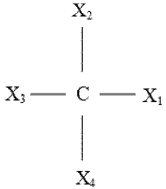

In some examples, the second, carbon-containing precursor 215 may include a perhalogenated alkane, a perhalogenated alkene, a perhalogenated alkyne, a perhalogenated ethylene, a perhalogenated benzene, a perhalogenated toluene, a perhalogenated arene, a difluoroacetylene, a dichloroacetylene, a dibromoacetylene, a diiodoacetylene, carbon monoxide, or any combination thereof. In some additional examples, the second, carbon-containing precursor 215 may include a carboxylic acid halide, a halogenated carboxylic acid halide, a perhalogenated carboxylic acid halide, a di(carboxylic acid) di-halide, chloral. Examples of, respectively, each of these families can be formic acid chloride, HCOCl; chloroacetic acid chloride, ClCH₂-COCl; trifluoracetic acid chloride, CF₃-COCl; oxalic acid dichloride, ClOC-COCl; chloral, CCl₃-CHO. In more additional examples, the second, carbon-containing precursor 215 may include a carboxylic acid, a halogenated carboxylic acid, a perhalogenated carboxylic acid, a di-carboxylic acid, or a molecule having a carboxylic acid functional group and a carboxylic acid halide functional group. Examples of, respectively, each of these families can be formic acid, HCOOH; chloroacetic acid, ClCH₂-COOH; trifluoracetic acid, CF₃-COOH; oxalic acid, HOOC-COOH; oxalic acid chloride, HOOC-COCl.

In some examples, the first precursor 205 may be reacted with the base material and/or the second carbon-containing precursor may be reacted with the first compound 220 to form the layer of carbon (e.g., second compound 230) at a temperature at or below 500°C. Performing the reaction at this temperature may be possible due to a reactivity of the silicon, germanium, or tin in the first precursor 205 and/or the first compound 220. Additionally, or alternatively, the temperature may be at or below 400°C. Performing the reaction at this temperature may be possible due to a reactivity of the germanium or tin in the first precursor 205 and/or the first compound 220 (e.g., as compared to a first precursor 205 and/or a first compound 220 that includes silicon instead of germanium or tin). Additionally, or alternatively, the temperature may be at or below 300°C. For instance, the temperature may be between 288°C and 357°C. Performing the reaction in this temperature range may be possible due to the use of (SiMe₃)₂ as the first precursor 205 (e.g., as compared to a first precursor 205 and/or a first compound 220 that additionally, or alternatively, includes at least acetylene). Performing the reaction between 288°C and 357°C may result in a lower resistivity, a lower contamination by residual bromine, or both. For example, the lower resistivity may be an example of 14 miliohm.cm as compared to 16 miliohm.com. In some cases, using (SiMe₃)₂ as the first precursor 205 to deposit conductive films may result in a thicker deposition layer with a GPC of at least 2.5 Ang.

In some cases, the reaction may be performed at 357°C which may result in 75 nm conductive film thickness. In some examples, the reaction may be performed at 337°C which may result in between 42 and 44 nm conductive film thickness. Performing the reaction at 317°C may result in between 26 and 27 nm conductive film thickness. Performing the reaction at 297°C may result in 17 nm conductive film thickness. Performing the reaction at 288°C may result in 12 nm conductive film thickness. In such cases, as the reaction temperature decreases, the conductive film thickness may also decrease.

In some examples, the reaction may be performed with shorter soaks with (SiMe₃)₂ as the first precursor 205 (e.g., thirty second soaks as compared to sixty second soaks). A soak may be an example of a duration of time that the first precursor 205 is maintained in the reactor before purging the first precursor 205 from the reactor. In such cases, the sample may be grown (e.g., conductive film may be deposited) by using a thirty second soak of (SiMe₃)₂ as the first precursor 205. In such case, the reaction may be performed at 357°C which may result in 37 nm conductive film thickness. The reaction performed at 357°C may include 93.5 atomic weight percent of carbon, 1.5 atomic weight percent of oxygen, 2.6% atomic weight percent of silicon, and 2.4% atomic weight percent of bromine. Performing the reaction at 357°C with longer soaks (e.g., sixty second soaks of (SiMe₃)₂ as the first precursor 205) may result in 69 nm conductive film thickness. In some cases, the reaction may be performed at 357°C with a soak time of 170 second soak which may result in 96 nm conductive film thickness. The reaction performed at 357°C with a 170 second soak time may include 91.8 atomic weight percent of carbon, 2.5 atomic weight percent of oxygen, 3.8% atomic weight percent of silicon, and 2.1% atomic weight percent of bromine. In such cases, performing the reaction with a shorter soak time may result in a reduced film thickness.

Additionally, or alternatively, (SiMe₃)₂ as the first precursor 205 may be replaced with a trisiliane, a polysilane, or both. In some cases, the first precursor 205 (e.g., (SiMe₃)₂, or (GeMe₃)₂, or (SnMe₃)₂, or (PbMe₃)₂) may be replaced with a trigermane or a polygermane, a tristannane or a polystannane, a triplumbanne or a polyplumbane or both to enable depositions at lower temperatures due to the increased reactivity of digermanes, distannanes, and diplumbanes.

In some examples, the term 'alkyl' may refer to a saturated hydrocarbon chain, an unsaturated hydrocarbon chain, a linear hydrocarbon chain, a branched hydrocarbon chain, or a cyclic hydrocarbon chain including from one carbon atom (e.g., C₁) to ten carbon atoms (e.g., C₁₀).

In some examples, the term "substituted" may refer to a functional group where one or more hydrogen atoms have been replaced by another functional group, such as an alkyl group, an alkoxide group, an amide group, an amine group, or a halogen group.

In some examples, a "halide" may refer to a fluoro, a chloro, a bromo, or an iodo.

In some examples, the term "alkoxy" may refer to an alkyl group linked to an oxygen atom including, but not limited to, a methoxy group, an ethoxy group, a propoxy group, a butoxy group, a pentoxy group, a hexoxy group, a heptoxy group, an octoxy group, a nonoxy group, a decoxy group, a phenyloxide, an aryloxide, an alkylsilyoxide, an alkoxy-substituted alkoxy group (e.g., a polyether group), such as a methoxy group, a methoxy ethoxy group, an ethoxy methoxy group, an ethoxy group, and a ethoxy ethoxy group. The alkoxy may be linear or branched, such as iso-propylalkoxide or a tert-butylalkoxide. The alkoxy may have a chelating group. Chelating groups may, for instance, refer to a dialkylamido group or an alkylsulfide group.

In some examples, a "methyl" may refer to a compound with the chemical formula CH₃, where "C" may refer to carbon and "H" may refer to hydrogen (or deuterium). In some examples, an "ethyl" may refer to a compound with the chemical formula CH₂CH₃. In some examples, a "propyl" may refer to a compound with the chemical formula CH₂CH₂CH₃. In some examples, an "isopropyl" may refer to a compound with the chemical formula (CH₃)₂CH-. In some examples, an alkyl group may refer to a compound with a chemical formula CₙH₂ₙ₊₁, where n is an integer greater than or equal to 1. In some examples, an alkyl-sulfide may refer to a -SR moiety, where R is an alkyl group, an alkyl-selenide may refer to a -SeR moiety, where R is an alkyl group, an alkyl-telluride may refer to a -TeR moiety, where R is an alkyl group. In some examples, a dialkylamide may refer to an amide moeity with two alkyl groups, such as -NR'R", where R' and R" are alkyl groups.

A dimethylamino is the moiety with chemical formula (CH₃)₂N-, where "C" may refer to carbon, "H" may refer to hydrogen (or deuterium), and "N" may refer to nitrogen. In some examples, a diethylamino is the moiety with chemical formula (CH₃CH₂)₂N-. In some examples, ethylmethylamino is the moiety with chemical formula (CH3CH2)(CH3)N-.

In some examples, the methods or aspects of the methods described herein may be performed using chemical vapor deposition (CVD). For instance, the first precursor 205 may be deposited using CVD and the second precursor may react with the first compound 220 via the methods described herein, the first compound 220 may be formed with the first precursor 205 via the methods described herein and the second precursor 215 may be deposited onto the first compound 220 using CVD, or the first precursor 205 and the second precursor 215 may both be deposited using CVD.

Independently including or selecting from a set of elements and/or compound may refer to a capability that a first element or compound may be substituted for another while still producing a precursor usable for forming a compound on a surface of a material.

It should be noted that there may be examples in which the second, carbon-containing precursor 215 may react with the layer 210 to form a third compound. In some such examples, the first precursor 205 may react with the third compound to form a fourth compound. The process may be repeated and such that multiple layers of carbon (e.g., carbon with above 85% purity, carbon with above 90% purity, carbon with above 95% purity, carbon with above 99% purity, carbon with above 99.9% purity) may form.

While the second compound 230 (e.g., carbon or a carbon material) may be formed by sequentially introducing and reacting the first precursor 205 and the second precursor 215 (i.e., in an ABAB ... sequence), the precursors may be introduced in a different order than that described above (e.g., in a BABA ... sequence, an AABAAB . . . sequence, an ABBABB sequence) depending on the composition of the second compound 230. For instance, first precursor 205 may be introduced followed by the introduction of the second precursor 215. Depending on the composition of the second compound 230, more than one introduction (e.g., pulse) of the first precursor 205 or the second precursor 215 may be conducted before the second precursor 215 or the first precursor 205, respectively, are introduced.

In some examples, a first molecule for the first precursor 205 (i.e., precursor 1-a) and a second molecule for the second precursor 215 (i.e., precursor 2-a) may be introduced repeatedly for one or more cycles (e.g., *AA* times or *AA* cycles, where *AA* is some positive integer). After repeatedly introducing precursor 1-a and precursor 2-a over the multiple cycles, a third molecule for the first precursor 205 (i.e., precursor 1-b) and a fourth molecule for the second precursor (i.e., precursor 2-b) may be introduced repeatedly for one or more cycles (e.g., *BB* times or *BB* cycles, where *BB* is some positive integer). This process may continue for multiple other precursors up to a predefined amount (e.g., *CC* times or *CC* cycles for precursors 1-c and 2-c, *DD* times or *DD* cycles for precursors 1-d and 2-d, and so on, up to *XX* times or *XX* cycles for precursors 1-x and 2-x, where *CC, DD,* and *XX* are all positive integers). After this process continues up to the predefined amount, the process may repeat (e.g., precursors 1-a and 2-a may be used again for *AA* times or *AA* cycles). It should be noted that each of the molecules used as precursors for each cycle may be selected from the same molecule relative to a different cycle or different molecules from the molecules described herein for first precursor 205 and second precursor 215.

In some such examples, a third precursor may be reacted with a layer of carbon (e.g., second compound 230) to form a second carbon compound on the layer of carbon, where the third precursor is an acetylene, a diacetylene, a tri-acetylene, a polyacetylene, an alkene, or an arene and includes at least one of germanium, silicon, or tin. Additionally, a fourth, carbon-containing precursor may be reacted with the second carbon compound to form a second layer of carbon on the layer of carbon (e.g., on second compound 230). In some such examples, a set of X precursor pairs may be identified, where each precursor pair of the set of X precursor pairs includes one of a first set of precursors and one of a second set of precursors, where each precursor pair has an associated quantity of cycles, where X is an integer greater than or equal to 2, where each precursor of the first set of precursors is independently selected from an acetylene, a diacetylene, a tri-acetylene, a polyacetylene, an alkene, or an arene and includes at least one of germanium, silicon, or tin, and where each precursor of the second set of precursors is a carbon-containing precursor. Additionally, according to the associated quantity of cycles for each precursor pair of the set of X precursor pairs and to form a respective carbon film associated with the precursor pair, a reacting of the one of the first set of precursors to form a respective carbon compound and a reacting of the one of the second set of precursors with the respective carbon compound to form one or more layers of carbon may be performed.

In some examples, a layer of carbon may be exposed to the third precursor to form a second carbon compound on multiple stacks of materials, where the third precursor is an acetylene, a diacetylene, a tri-acetylene, a polyacetylene, an alkene, or an arene and includes at least one of germanium, silicon, or tin. Additionally, the second carbon compound may be exposed to the fourth, carbon-containing precursor to form a second layer of carbon on the second layer of carbon. In some such examples, according to the associated quantity of cycles for each precursor pair of the set of X precursor pairs and to form a respective carbon film associated with the precursor pair, an exposing with the one of the first set of precursors to form a respective carbon compound and an exposing of the respective carbon compound with the one of the second set of precursors to form one or more layers of carbon may be performed.

In some examples, the second layer of carbon may be formed on the layer of carbon (e.g., second compound 230) by exposing the layer of carbon to the third precursor to form the second carbon compound on the multiple stacks of materials and exposing the second carbon compound to the fourth, carbon-containing precursor to form the second layer of carbon on the layer of carbon., where the third precursor is an acetylene, a diacetylene, a tri-acetylene, a polyacetylene, an alkene, or an arene and comprises at least one of germanium, silicon, or tin. In some examples, a set of carbon films may be formed, where each of the set of carbon films is associated with a precursor pair of a set of X precursor pairs, where each precursor pair of the set of X precursor pairs includes one of a first set of precursors and one of a second set of precursors, where each precursors pair has an associated quantity of cycles, where each precursor of the first set of precursors includes at least one of germanium, silicon, or tin, where each precursor of the second set of precursors is a carbon-containing precursor, and where each of the set of carbons films is formed by performing, according to the associated quantity of cycles for the associated precursor pair of the set of precursor pairs, an exposing with the one of the first set of precursors to form a respective carbon compound and an exposing of the respective carbon compound with the one of the second set of precursors to form one or more layers of carbon.

The methods described herein may have one or more advantages. For instance, using the first precursor 205 and/or the second precursor 215 as described herein may enable the carbon content of second compound 230 to be as high as 85%, 90%, 95%, 99%, 99.9%, or 100%, may enable a deposited film to contain up to 75%, 85%, 90%, 95%, 99%, 99.9%, or 100% sp² carbon, and/or may enable that carbon film deposited by ALD is conformal at a bottom of 3D structures (e.g., deep 3D structures, such as 3D structures with a depth above a threshold amount). In some examples, a fraction of sp² carbon may be controllable to a defined target amount depending on which compound is chosen for the first precursor. Accordingly, the method described herein may enable modulating an sp² fraction of a film. Additionally, or alternatively, using germanium and/or or tin in the first precursor 205 may enable reactions (e.g., the formation of first compound 220 and/or the formation of second compound 230) to occur at lower temperatures as compared to precursors that do not include germanium and/or tin (e.g., trimeythlsilyl precursors). Additionally, or alternatively, using germanium and/or tin in the first precursor 205 may enable deposition that occurs more quickly for a given temperature as compared to precursors that do not include germanium and/or tin.

**FIG. 3** illustrates an example of an electronic device 300 that supports methods for depositing carbon conducting films in accordance with examples as disclosed herein. The electronic device 300 may include a base material 305 with one or more features 310 (e.g., pillars, stacks), where the base material 305 and the one or more features 310 may be covered in a material 315. Each feature 310 may include materials 320, 325, 330, 335, and 340, where each of material 320, 325, 330, 335, and 340 may be an example of a chalcogenide material, an organic (e.g., carbon) material, a carbon allotrope (e.g., graphite), a reactive metal (e.g., tungsten, aluminum, or tantalum), a thermally-sensitive material, an oxidation-sensitive material, or any combination thereof. Some of material 320, 325, 330, 335, and 340 may be examples of other materials. In some examples, base material 305 or the combination of base material 305 and one or more features 310 may be an example of a base material 105 as described with reference to FIG. 1 or a layer 210 as described with reference to FIG. 2. Additionally, or alternatively, material 315 may be an example of a second compound 125 as described with reference to FIG. 1 or a second compound 230 as described with reference to FIG. 2.

While FIG. 3 illustrates feature 310 including five materials, each feature may be made up of a single material or two or more materials (e.g., including more than five materials). The features may be separated from each other by openings 322. The materials of the features 310 may be formed adjacent to (e.g., over) the base material 305 using techniques such as photolithography, physical vapor deposition (PVD), chemical vapor deposition (CVD), or ALD. In some examples, the base material 305 may include one or more materials, layers, structures, or regions thereon. The features 310 may be considered high aspect ratio (HAR) features, where HAR may for instance correspond to greater than or equal to an aspect ratio of 10:1, greater than or equal to an aspect ratio of 20:1, greater than or equal to an aspect ratio of 25:1, or greater than or equal to an aspect ratio of 50:1. In some examples, the material 315 may be formed on one of but not both base material 305 and the one or more features 310. Additionally, or alternatively, the material 315 may be formed as a material within each of the one or more features 310. Additionally, or alternatively, the material 315 may be formed on a planar material or on a low aspect ratio features of an electronic device.

The material 315 may be formed over the features 310 according to the aspects described herein. For instance, the material 315 may be formed by sequentially exposing the features 310 of the electronic device 300 to a first precursor (e.g., first precursor 205) and a second precursor (e.g., second precursor 215) as described herein. The material 315 may function as a conductive component of electronic device 300, such as a transistor, a capacitor, an electrode, an etch-stop material, a gate, a barrier material, or a spacer material. One or more materials and/or structure, such as a gate, may subsequently be formed in the openings 322 by techniques such as photolithography, PVD, CVD, or ALD and/or additional process acts conducted to form a complete electronic device containing electronic device 300.

The material 315 may be conformally formed on the features 310 according to the aspects described herein. For instance, the thickness of material 315 on sidewalls of the features 310 may be substantially uniform. For instance, the material 315 may be formed to a thickness ranging from a monolayer to 100 nm. Alternatively, the material 315 may be formed at a greater thickness. The material 315 may be in direct contact with each material of the features 310 or some materials of the features 310. Additionally, or alternatively, the material 315 may be in contact with the base material 305.

In some examples, the base material 305 may be a structure on a substrate (e.g., a wafer). In some such examples, the base material 305 may span in a first direction and a second direction, where the first direction is orthogonal to the second direction. Additionally, a memory device including the base material 305 may include word lines extending along the first direction and/or the second direction and bit lines extending along a third direction orthogonal to the first direction and the second direction. In some such examples, a stack of materials (e.g., a sequence of materials, such as a feature 310) may be formed in one or more recesses of the word lines, where the stack may extend along the first direction and/or the second direction and where the sequence of materials may include a memory cell (e.g., a chalcogenide element). In some examples, the stacks may each be coupled with one word line and one bit line. In some examples, the techniques described herein may be used to form layers of carbon on the base material 305, the word lines, the bit lines, the stacks, or any combination thereof.

**FIG. 4** shows a flowchart illustrating a method 400 that supports methods for depositing carbon conducting films in accordance with examples as disclosed herein. The operations of method 400 may be implemented by a manufacturing system or one or more controllers associated with a manufacturing system. In some examples, one or more controllers may execute a set of instructions to control one or more functional elements of the manufacturing system to perform the described functions. Additionally, or alternatively, one or more controllers may perform aspects of the described functions using special-purpose hardware.

At 405, the method may include reacting a first precursor with a base material to form a carbon compound on the base material, where the first precursor comprises at least one of germanium, silicon, or tin. The operations of 405 may be performed in accordance with examples as disclosed herein.

At 410, the method may include reacting a second, carbon-containing precursor with the carbon compound to form a layer of carbon on the base material. The operations of 410 may be performed in accordance with examples as disclosed herein.

In some examples, an apparatus (e.g., a manufacturing system) as described herein may perform a method or methods, such as the method 400. The apparatus may include features, circuitry, logic, means, or instructions (e.g., a non-transitory computer-readable medium storing instructions executable by one or more controllers to control one or more functional elements of the manufacturing system), or any combination thereof for performing the following aspects of the present disclosure:
Aspect 1: A method or apparatus including operations, features, circuitry, logic, means, or instructions, or any combination thereof for reacting a first precursor with a base material to form a carbon compound on the base material, where the first precursor includes at least one of germanium, silicon, or tin and reacting a second, carbon-containing precursor with the carbon compound to form a layer of carbon on the base material.
Aspect 2: The method or apparatus of aspect 1, where the first precursor comprises a chemical formula R1R2R3A-ZR4R5R6, wherein A or Z are independently selected from the germanium, the tin, the silicon or a lead.
Aspect 3: The method or apparatus of any of aspects 1 through 2, where the first precursor comprises a chemical formula R1R2R3A-ZR4R5R6, wherein each of R1, R2, R3, R4, R5, and R6 are independently selected from hydrogen, an alkyl group, an alkoxy, a di-alkylamide, an alkyl-sulfide, an alkyl-selenide, a halide, or an alkyl-telluride.
Aspect 4: The method or apparatus of any of aspects 1 through 3, where the first precursor comprises a chemical formula R1R2R3A-ZR4R5R6, wherein A or Z are the silicon, and wherein each of R1, R2, R3, R4, R5, and R6 are an alkyl group.
Aspect 5: The method or apparatus of any of aspects 1 through 4, where the second, carbon-containing precursor comprises a chemical formula CX1X2X3X4, wherein each of X1, X2, X3, and X4 are independently selected from a fluorine, a chlorine, a bromine, an iodine, a methoxy, an ethoxy, an alkoxy, a sulfoxy, a selenoxy, a telluroxy, a dimethylamino, a diethylamino, an ethylmethylamino, a di-alkylamino, a hydrogen, or any combination thereof.
Aspect 6: The method or apparatus of any of aspects 1 through 5, where the second, carbon-containing precursor comprises a chemical formula CX1X2X3X4, wherein each of X1, X2, X3, and X4 are a bromine.
Aspect 7: The method or apparatus of any of aspects 1 through 6, where reacting the first precursor with the base material or reacting the second, carbon-containing precursor with the carbon compound to form the layer of carbon comprises conducting the reacting at a temperature at or below 400°C.
Aspect 8: The method or apparatus of aspect 7, wherein the temperature is at or below 300°C.

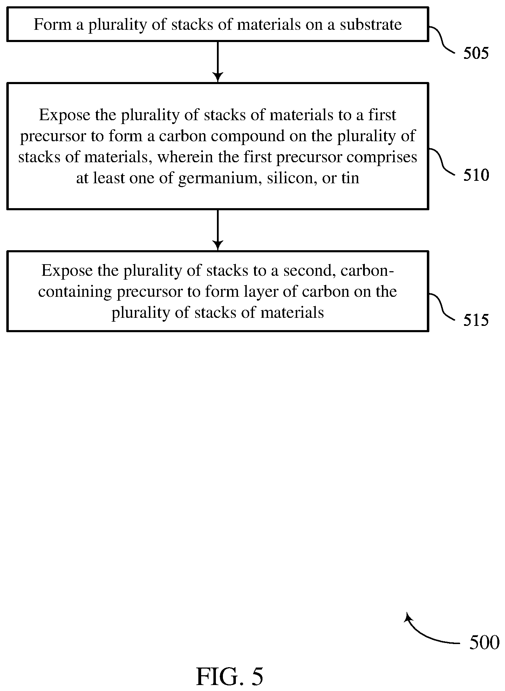

**FIG. 5** shows a flowchart illustrating a method 500 that supports methods for depositing carbon conducting films in accordance with examples as disclosed herein. The operations of method 500 may be implemented by a manufacturing system or one or more controllers associated with a manufacturing system. In some examples, one or more controllers may execute a set of instructions to control one or more functional elements of the manufacturing system to perform the described functions. Additionally, or alternatively, one or more controllers may perform aspects of the described functions using special-purpose hardware.

At 505, the method may include forming a plurality of stacks of materials on a substrate. The operations of 505 may be performed in accordance with examples as disclosed herein.

At 510, the method may include exposing the plurality of stacks of materials to a first precursor to form a carbon compound on the plurality of stacks of materials, where the first precursor comprises at least one of germanium, silicon, or tin. The operations of 510 may be performed in accordance with examples as disclosed herein.

At 515, the method may include exposing the plurality of stacks to a second, carbon-containing precursor to form layer of carbon on the plurality of stacks of materials. The operations of 515 may be performed in accordance with examples as disclosed herein.

In some examples, an apparatus (e.g., manufacturing system) as described herein may perform a method or methods, such as the method 500. The apparatus may include features, circuitry, logic, means, or instructions (e.g., a non-transitory computer-readable medium storing instructions executable by one or more controllers to control one or more functional elements of the manufacturing system), or any combination thereof for performing the following aspects of the present disclosure:

Aspect 9: A method or apparatus including operations, features, circuitry, logic, means, or instructions, or any combination thereof for forming a plurality of stacks of materials on a substrate; exposing the plurality of stacks of materials to a first precursor to form a carbon compound on the plurality of stacks of materials, where the first precursor comprises at least one of germanium, silicon, or tin; and exposing the plurality of stacks to a second, carbon-containing precursor to form layer of carbon on the plurality of stacks of materials.

Aspect 10: The method or apparatus of aspect 9, where the first precursor comprises a chemical formula R1R2R3A-ZR4R5R6, wherein A or Z are independently selected from the germanium, the tin, the silicon, or a lead.

Aspect 11: The method or apparatus of aspect 9 through 10, where the first precursor comprises a chemical formula R1R2R3A-ZR4R5R6, wherein each of R1, R2, R3, R4, R5, and R6 are independently selected from hydrogen, an alkyl group, an alkoxy, a di-alkylamide, an alkyl-sulfide, an alkyl-selenide, a halide, or an alkyl-telluride.

Aspect 12: The method or apparatus of any of aspects 9 through 11, where the first precursor comprises a chemical formula R1R2R3A-ZR4R5R6, wherein A or Z are the silicon, and wherein each of R1, R2, R3, R4, R5, and R6 are an alkyl group.

Aspect 13: The method or apparatus of any of aspects 9 through 12, where the second, carbon-containing precursor comprises a chemical formula CX1X2X3X4, wherein each of X1, X2, X3, and X4 are independently selected from a fluorine, a chlorine, a bromine, an iodine, a methoxy, an ethoxy, an alkoxy, a sulfoxy, a selenoxy, a telluroxy, a dimethylamino, a diethylamino, an ethylmethylamino, a di-alkylamino, a hydrogen, or any combination thereof.

Aspect 14: The method or apparatus of any of aspects 9 through 13, where the second, carbon-containing precursor comprises a chemical formula CX1X2X3X4, wherein each of X1, X2, X3, and X4 are a bromine.

Aspect 15: The method or apparatus of any of aspects 9 through 14, where reacting the first precursor with a base material or reacting the second, carbon-containing precursor with the carbon compound to form the layer of carbon comprises conducting the reacting at a temperature at or below 400°C.

Aspect 16: The method or apparatus of aspect 15, where the temperature is at or below 300°C.

It should be noted that the methods described herein describe possible implementations, and that the operations and the steps may be rearranged or otherwise modified and that other implementations are possible. Further, portions from two or more of the methods may be combined.

An apparatus is described. The following provides an overview of aspects of the apparatus as described herein:

Aspect 17: An apparatus, including: a plurality of stacks of materials on a substrate, at least one material of the plurality of stacks of materials including a memory material; and a layer of carbon on the plurality of stacks of materials formed by exposing the plurality of stacks of materials to a first precursor comprising at least one of germanium, silicon, or tin and by exposing the plurality of stacks of materials to a second, carbon-containing precursor.

Aspect 18: The apparatus of aspect 17, where the first precursor comprises a chemical formula R1R2R3A-ZR4R5R6, wherein A or Z are independently selected from the germanium, the tin, the silicon, or a lead.

Aspect 19: The apparatus of aspects 17 through 18, where the first precursor comprises a chemical formula R1R2R3A-ZR4R5R6, wherein each of R1, R2, R3, R4, R5, and R6 are independently selected from hydrogen, an alkyl group, an alkoxy, a di-alkylamide, an alkyl-sulfide, an alkyl-selenide, a halide, or an alkyl-telluride.

Aspect 20: The apparatus of aspects 17 through 19, where the first precursor comprises a chemical formula R1R2R3A-ZR4R5R6, wherein A or Z are the silicon, and wherein each of R1, R2, R3, R4, R5, and R6 are an alkyl group.

Aspect 21: The apparatus of any of aspects 17 through 20, where the second, carbon-containing precursor comprises a chemical formula CX1X2X3X4, wherein each of X1, X2, X3, and X4 are independently selected from a fluorine, a chlorine, a bromine, an iodine, a methoxy, an ethoxy, an alkoxy, a sulfoxy, a selenoxy, a telluroxy, a dimethylamino, a diethylamino, an ethylmethylamino, a di-alkylamino, a hydrogen, or any combination thereof.

Aspect 22: The apparatus of any of aspects 17 through 21, where the second, carbon-containing precursor comprises a chemical formula CX1X2X3X4, wherein each of X1, X2, X3, and X4 are a bromine.

Aspect 23: The apparatus of any of aspects 17 through 22, where reacting the first precursor with a base material or reacting the second, carbon-containing precursor with the carbon compound to form the layer of carbon comprises conducting the reacting at a temperature at or below 400°C.

Aspect 24: The apparatus of aspect 23, where the temperature is at or below 300°C.

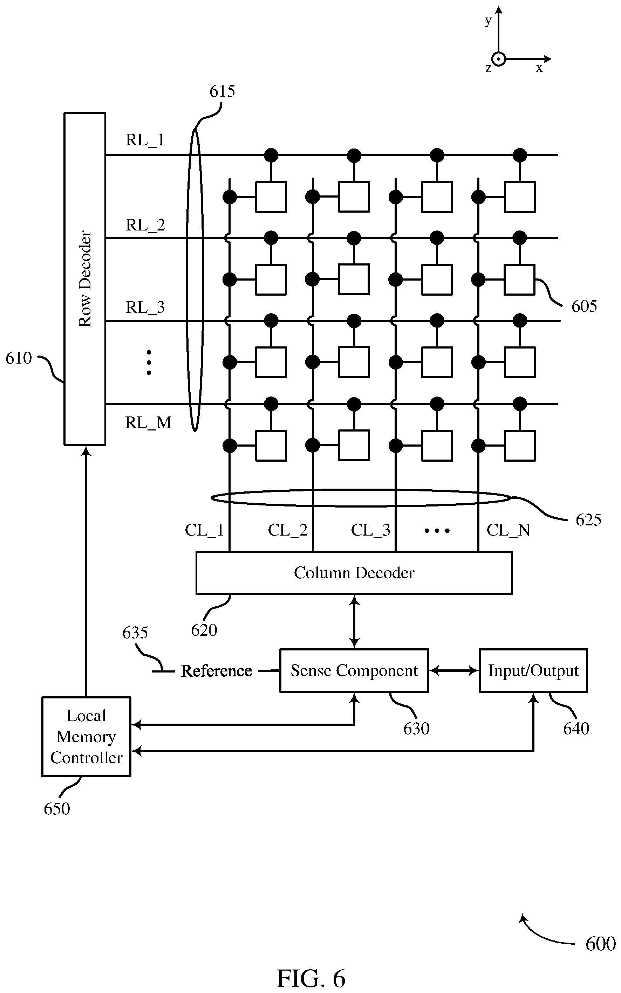

**FIG. 6** shows an example of a memory device 600 that supports methods for depositing carbon conducting films in accordance with examples as disclosed herein. In some examples, the memory device 600 may be referred to as or include a memory die, a memory chip, or an electronic memory apparatus. The memory device 600 may be operable to provide locations to store information (e.g., physical memory addresses) that may be used by a system (e.g., a host device coupled with the memory device 600, for writing information, for reading information).

The memory device 600 may include one or more memory cells 605 that each may be programmable to store different logic states (e.g., a programmed one of a set of two or more possible states). For example, a memory cell 605 may be operable to store one bit of information at a time (e.g., a logic 0 or a logic 1). In some examples, a memory cell 605 (e.g., a multi-level memory cell 605) may be operable to store more than one bit of information at a time (e.g., a logic 00, logic 01, logic 10, a logic 11). In some examples, the memory cells 605 may be arranged in an array.

A memory cell 605 may store a logic state using a configurable material, which may be referred to as a memory element, a storage element, a memory storage element, a material element, a material memory element, a material portion, or a polarity-written material portion, among others. A configurable material of a memory cell 605 may refer to a chalcogenide-based storage component. For example, a chalcogenide storage element may be used in a phase change memory cell, a thresholding memory cell, or a self-selecting memory cell, among other architectures.

In some examples, the material of a memory cell 605 may include a chalcogenide material or other alloy including selenium (Se), tellurium (Te), arsenic (As), antimony (Sb), carbon (C), germanium (Ge), silicon (Si), or indium (In), or various combinations thereof. In some examples, a chalcogenide material having primarily selenium (Se), arsenic (As), and germanium (Ge) may be referred to as a SAG-alloy. In some examples, a SAG-alloy may also include silicon (Si) and such chalcogenide material may be referred to as SiSAG-alloy. In some examples, SAG-alloy may include silicon (Si) or indium (In) or a combination thereof and such chalcogenide materials may be referred to as SiSAG-alloy or InSAG-alloy, respectively, or a combination thereof. In some examples, the chalcogenide material may include additional elements such as hydrogen (H), oxygen (O), nitrogen (N), chlorine (Cl), or fluorine (F), each in atomic or molecular forms.

In some examples, a memory cell 605 may be an example of a phase change memory cell. In such examples, the material used in the memory cell 605 may be based on an alloy (such as the alloys listed above) and may be operated so as to change to different physical state (e.g., undergo a phase change) during normal operation of the memory cell 605. For example, a phase change memory cell 605 may be associated with a relatively disordered atomic configuration (e.g., a relatively amorphous state) and a relatively ordered atomic configuration (e.g., a relatively crystalline state). A relatively disordered atomic configuration may correspond to a first logic state (e.g., a RESET state, a logic 0) and a relatively ordered atomic configuration may correspond to a second logic state (e.g., a logic state different than the first logic state, a SET state, a logic 1).

In some examples (e.g., for thresholding memory cells 605, for self-selecting memory cells 605), some or all of the set of logic states supported by the memory cells 605 may be associated with a relatively disordered atomic configuration of a chalcogenide material (e.g., the material in an amorphous state may be operable to store different logic states). In some examples, the storage element of a memory cell 605 may be an example of a self-selecting storage element. In such examples, the material used in the memory cell 605 may be based on an alloy (e.g., the alloys listed above) and may be operated so as to undergo a change to a different physical state during normal operation of the memory cell 605. For example, a self-selecting or thresholding memory cell 605 may have a high threshold voltage state and a low threshold voltage state, where a corresponding "threshold voltage" may refer to a voltage at which or above which the memory cell 605 transitions from a relatively higher-resistance (e.g., non-conductive) state to a relatively lower-resistance (e.g., conductive) state, such as in response to an applied voltage. A high threshold voltage state may correspond to a first logic state (e.g., a RESET state, a logic 0) and a low threshold voltage state may correspond to a second logic state (e.g., a logic state different than the first logic state, a SET state, a logic 1).

During a write operation (e.g., a programming operation) of a self-selecting or thresholding memory cell 605, a polarity used for a write operation may influence (e.g., determine, set, program) a behavior or characteristic of the material of the memory cell 605, such as a thresholding characteristic (e.g., a threshold voltage) of the material. A difference between thresholding characteristics (e.g., resistivity characteristics, conductivity characteristics) of the material of the memory cell 605 for different logic states stored by the material of the memory cell 605 (e.g., a difference between threshold voltages when the material is storing a logic state '0' versus a logic state '1') may correspond to the read window of the memory cell 605.

The memory device 600 may include access lines (e.g., row lines 615 each extending along an illustrative x-direction, column lines 625 each extending along an illustrative y-direction) arranged in a pattern, such as a grid-like pattern. Access lines may be formed with one or more conductive materials. In some examples, row lines 615, or some portion thereof, may be referred to as word lines. In some examples, column lines 625, or some portion thereof, may be referred to as digit lines or bit lines. References to access lines, or their analogues, are interchangeable without loss of understanding. Memory cells 605 may be positioned at intersections of access lines, such as row lines 615 and the column lines 625. In some examples, memory cells 605 may also be arranged (e.g., addressed) along an illustrative z-direction, such as in an implementation of sets of memory cells 605 being located at different levels (e.g., layers, decks, planes, tiers) along the illustrative z-direction. In some examples, a memory device 600 that includes memory cells 605 at different levels may be supported by a different configuration of access lines, decoders, and other supporting circuitry than shown.

Operations such as read operations and write operations may be performed on the memory cells 605 by activating access lines such as one or more of a row line 615 or a column line 625, among other access lines associated with alternative configurations. For example, by activating a row line 615 and a column line 625 (e.g., applying a voltage to the row line 615 or the column line 625), a memory cell 605 may be accessed in accordance with their intersection. An intersection of a row line 615 and a column line 625, among other access lines, in various two-dimensional or three-dimensional configuration may be referred to as an address of a memory cell 605. In some examples, an access line may be a conductive line coupled with a memory cell 605 and may be used to perform access operations on the memory cell 605. In some examples, the memory device 600 may perform operations responsive to commands, which may be issued by a host device coupled with the memory device 600 or may be generated by the memory device 600 (e.g., by a local memory controller 650).

Accessing the memory cells 605 may be controlled through one or more decoders, such as a row decoder 610 or a column decoder 620, among other examples. For example, a row decoder 610 may receive a row address from the local memory controller 650 and activate a row line 615 based on the received row address. A column decoder 620 may receive a column address from the local memory controller 650 and may activate a column line 625 based on the received column address.

The sense component 630 may be operable to detect a state (e.g., a material state, a resistance state, a threshold state) of a memory cell 605 and determine a logic state of the memory cell 605 based on the detected state. The sense component 630 may include one or more sense amplifiers to convert (e.g., amplify) a signal resulting from accessing the memory cell 605 (e.g., a signal of a column line 625 or other access line). The sense component 630 may compare a signal detected from the memory cell 605 to a reference 635 (e.g., a reference voltage, a reference charge, a reference current). The detected logic state of the memory cell 605 may be provided as an output of the sense component 630 (e.g., to an input/output component 640), and may indicate the detected logic state to another component of the memory device 600 or to a host device coupled with the memory device 600.

The local memory controller 650 may control the accessing of memory cells 605 through the various components (e.g., a row decoder 610, a column decoder 620, a sense component 630, among other components). In some examples, one or more of a row decoder 610, a column decoder 620, and a sense component 630 may be co-located with the local memory controller 650. The local memory controller 650 may be operable to receive information (e.g., commands, data) from one or more different controllers (e.g., an external memory controller associated with a host device, another controller associated with the memory device 600), translate the information into a signaling that can be used by the memory device 600, perform one or more operations on the memory cells 605 and communicate data from the memory device 600 to a host device based on performing the one or more operations. The local memory controller 650 may generate row address signals and column address signals to activate access lines such as a target row line 615 and a target column line 625. The local memory controller 650 also may generate and control various signals (e.g., voltages, currents) used during the operation of the memory device 600. In general, the amplitude, the shape, or the duration of an applied signal discussed herein may be varied and may be different for the various operations discussed in operating the memory device 600.

The local memory controller 650 may be operable to perform one or more access operations on one or more memory cells 605 of the memory device 600. Examples of access operations may include a write operation, a read operation, a refresh operation, a precharge operation, or an activate operation, among others. In some examples, access operations may be performed by or otherwise coordinated by the local memory controller 650 in response to access commands (e.g., from a host device). The local memory controller 650 may be operable to perform other access operations not listed here or other operations related to the operating of the memory device 600 that are not directly related to accessing the memory cells 605.

The memory device 600 may be an example of the electronic device, as described herein with reference to FIGs. 1 through 5. For example, the techniques disclosed herein describe precursors capable of being used in ALD to produce one or more layers of carbon with the purity above the threshold amount for the memory device 600. For instance, the techniques may include exposing a material (e.g., a base material) to a first precursor and reacting the first precursor with the material to form a first carbon compound, where the first precursor may include at least one of germanium, silicon, or tin. Additionally, the techniques may include reacting a second, carbon-containing precursor with the carbon compound to form a layer of carbon on the material.

The memory device 600 may include any quantity of non-transitory computer readable media that support methods for depositing carbon conducting films, a row decoder 610, a column decoder 620, a sense component 630, or an input/output component 640, or any combination thereof may include or may access one or more non-transitory computer readable media storing instructions (e.g., firmware) for performing the functions ascribed herein to the memory device 600. For example, such instructions, if executed by the memory device 600, may cause the memory device 600 to perform one or more associated functions as described herein.

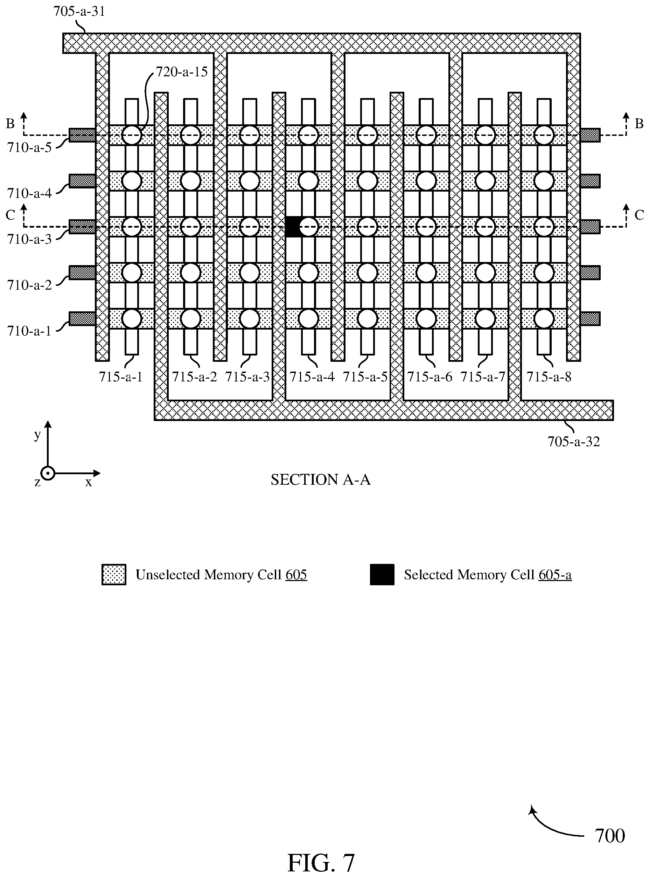

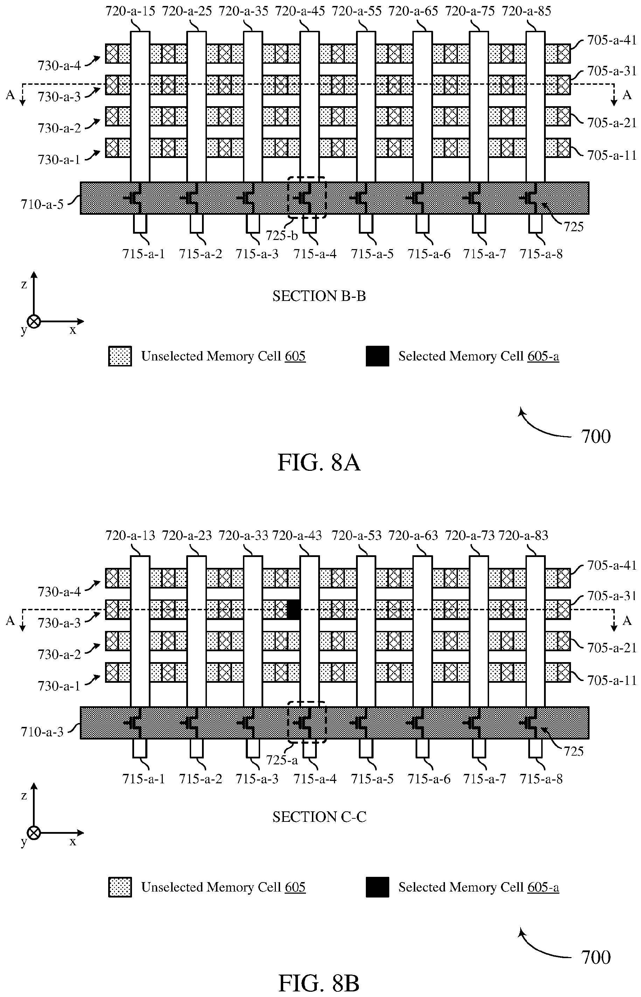

**FIGs. 7****,** **8A,** and **8B** show an example of a memory array 700 that supports methods for depositing carbon conducting films in accordance with examples as disclosed herein. The memory array 700 may be included in a memory device 600, and illustrates an example of a three-dimensional arrangement of memory cells 605 that may be accessed by various conductive structures (e.g., access lines). FIG. 7 illustrates a top section view (e.g., SECTION A-A) of the memory array 700 relative to a cut plane A-A as shown in FIGs. 8A and 8B. FIG. 8A illustrates a side section view (e.g., SECTION B-B) of the memory array 700 relative to a cut plane B-B as shown in FIG. 7. FIG. 8B illustrates a side section view (e.g., SECTION C-C) of the memory array 700 relative to a cut plane C-C as shown in FIG. 7. The section views may be examples of cross-sectional views of the memory array 700 with some aspects (e.g., dielectric structures) removed for clarity. Elements of the memory array 700 may be described relative to an x-direction, a y-direction, and a z-direction, as illustrated in each of FIGs. 7, 8A, and 8B. Although some elements included in FIGs. 7, 8A, and 8B are labeled with a numeric indicator, other corresponding elements are not labeled, although they are the same or would be understood to be similar, in an effort to increase visibility and clarity of the depicted features. Further, although some quantities of repeated elements are shown in the illustrative example of memory array 700, techniques in accordance with examples as described herein may be applicable to any quantity of such elements, or ratios of quantities between one repeated element and another.

In the example of memory array 700, memory cells 605 and word lines 705 may be distributed along the z-direction according to levels 730 (e.g., decks, layers, planes, tiers, as illustrated in FIGs. 8A and 8B). In some examples, the z-direction may be orthogonal to a substrate (not shown) of the memory array 700, which may be below the illustrated structures along the z-direction. Although the illustrative example of memory array 700 includes four levels 730, a memory array 700 in accordance with examples as disclosed herein may include any quantity of one or more levels 730 (e.g., 64 levels, 128 levels) along the z-direction.

Each word line 705 may be an example of a portion of an access line that is formed by one or more conductive materials (e.g., one or more metal portions, one or more metal alloy portions). As illustrated, a word line 705 may be formed in a comb structure, including portions (e.g., projections, tines) extending along the y-direction through gaps (e.g., alternating gaps) between pillars 720. For example, as illustrated, the memory array 700, may include two word lines 705 per level 730 (e.g., according to odd word lines 705-a-*n*1 and even word lines 705-a-*n*2 for a given level, *n*), where such word lines 705 of the same level 730 may be described as being interleaved (e.g., with portions of an odd word line 705-a-*n*1 projecting along the y-direction between portions of an even word line 705-a-*n*2, and vice versa). In some examples, an odd word line 705 (e.g., of a level 730) may be associated with a first memory cell 605 on a first side (e.g., along the x-direction) of a given pillar 720 and an even word line (e.g., of the same level 730) may be associated with a second memory cell 605 on a second side (e.g., along the x-direction, opposite the first memory cell 605) of the given pillar 720. Thus, in some examples, memory cells 605 of a given level 730 may be addressed (e.g., selected, activated) in accordance with an even word line 705 or an odd word line 705.

Each pillar 720 may be an example of a portion of an access line (e.g., a conductive pillar portion) that is formed by one or more conductive materials (e.g., one or more metal portions, one or more metal alloy portions). As illustrated, the pillars 720 may be arranged in a two-dimensional array (e.g., in an xy-plane) having a first quantity of pillars 720 along a first direction (e.g., eight pillars along the x-direction, eight rows of pillars), and having a second quantity of pillars 720 along a second direction (e.g., five pillars along the y-direction, five columns of pillars). Although the illustrative example of memory array 700 includes a two-dimensional arrangement of eight pillars 720 along the x-direction and five pillars 720 along the y-direction, a memory array 700 in accordance with examples as disclosed herein may include any quantity of pillars 720 along the x-direction and any quantity of pillars 720 along the y-direction. Further, as illustrated, each pillar 720 may be coupled with a respective set of memory cells 605 (e.g., along the z-direction, one or more memory cells 605 for each level 730). A pillar 720 may have a cross-sectional area in an xy-plane that extends along the z-direction. Although illustrated with a circular cross-sectional area in the xy-plane, a pillar 720 may be formed with a different shape, such as having an elliptical, square, rectangular, polygonal, or other cross-sectional area in an xy-plane.

The memory cells 605 each may include a chalcogenide material. In some examples, the memory cells 605 may be examples of thresholding memory cells. Each memory cell 605 may be accessed (e.g., addressed, selected) according to an intersection between a word line 705 (e.g., a level selection, which may include an even or odd selection within a level 730) and a pillar 720. For example, as illustrated, a selected memory cell 605-a of the level 730-a-3 may be accessed according to an intersection between the pillar 720-a-43 and the word line 705-a-32.

A memory cell 605 may be accessed (e.g., written to, read from) by applying an access bias (e.g., an access voltage, V_{access}, which may be a positive voltage or a negative voltage) across the memory cell 605. In some examples, an access bias may be applied by biasing a selected word line 705 with a first voltage (e.g., V_{access}/2) and by biasing a selected pillar 720 with a second voltage (e.g., -V_{access}/2), which may have an opposite sign relative to the first voltage. Regarding the selected memory cell 605-a, a corresponding access bias (e.g., the first voltage) may be applied to the word line 705-a-32, while other unselected word lines 705 may be grounded (e.g., biased to 0V). In some examples, a word line bias may be provided by a word line driver (not shown) coupled with one or more of the word lines 705.

To apply a corresponding access bias (e.g., the second voltage) to a pillar 720, the pillars 720 may be configured to be selectively coupled with a sense line 715 (e.g., a digit line, a column line, an access line extending along the y-direction) via a respective transistor 725 coupled between (e.g., physically, electrically) the pillar 720 and the sense line 715. In some examples, the transistors 725 may be vertical transistors (e.g., transistors having a channel along the z-direction, transistors having a semiconductor junction along the z-direction), which may be formed above the substrate of the memory array 700 using various techniques (e.g., thin film techniques). In some examples, a selected pillar 720, a selected sense line 715, or a combination thereof may be an example of a selected column line 625 described with reference to FIG. 6 (e.g., a bit line).

The transistors 725 (e.g., a channel portion of the transistors 725) may be activated by gate lines 710 (e.g., activation lines, selection lines, a row line, an access line extending along the x-direction) coupled with respective gates of a set of the transistors 725 (e.g., a set along the x-direction). In other words, each of the pillars 720 may have a first end (e.g., towards the negative z-direction, a bottom end) configured for coupling with an access line (e.g., a sense line 715). In some examples, the gate lines 710, the transistors 725, or both may be considered to be components of a row decoder 610 (e.g., as pillar decoder components). In some examples, the selection of (e.g., biasing of) pillars 720, or sense lines 715, or various combinations thereof, may be supported by a column decoder 620, or a sense component 630, or both.

To apply the corresponding access bias (e.g., -V_{access}/2) to the pillar 720-a-43, the sense line 715-a-4 may be biased with the access bias, and the gate line 710-a-3 may be grounded (e.g., biased to 0V) or otherwise biased with an activation voltage. In an example where the transistors 725 are n-type transistors, the gate line 710-a-3 being biased with a voltage that is relatively higher than the sense line 715-a-4 may activate the transistor 725-a (e.g., cause the transistor 725-a to operate in a conducting state), thereby coupling the pillar 720-a-43 with the sense line 715-a-4 and biasing the pillar 720-a-43 with the associated access bias. However, the transistors 725 may include different channel types, or may be operated in accordance with different biasing schemes, to support various access operations.

In some examples, unselected pillars 720 of the memory array 700 may be electrically floating when the transistor 725-a is activated, or may be coupled with another voltage source (e.g., grounded, via a high-resistance path, via a leakage path) to avoid a voltage drift of the pillars 720. For example, a ground voltage being applied to the gate line 710-a-3 may not activate other transistors coupled with the gate line 710-a-3, because the ground voltage of the gate line 710-a-3 may not be greater than the voltage of the other sense lines 715 (e.g., which may be biased with a ground voltage or may be floating). Further, other unselected gate lines 710, including gate line 710-a-5 as shown in FIG. 8A, may be biased with a voltage equal to or similar to an access bias (e.g., -V_{access}/2, or some other negative bias or bias relatively near the access bias voltage), such that transistors 725 along an unselected gate line 710 are not activated. Thus, the transistor 725-b coupled with the gate line 710-a-5 may be deactivated (e.g., operating in a non-conductive state), thereby isolating the voltage of the sense line 715-a-4 from the pillar 720-a-45, among other pillars 720.

In a write operation, a memory cell 605 may be written to by applying a write bias (e.g., where V_{access} = V_{write}, which may be a positive voltage or a negative voltage) across the memory cell 605. In some examples, a polarity of a write bias may influence (e.g., determine, set, program) a behavior or characteristic of the material of the memory cell 605, such as the threshold voltage of the material. For example, applying a write bias with a first polarity may set the material of the memory cell 605 with a first threshold voltage, which may be associated with storing a logic 0. Further, applying a write bias with a second polarity (e.g., opposite the first polarity) may set the material of the memory cell with a second threshold voltage, which may be associated with storing a logic 1. A difference between threshold voltages of the material of the memory cell 605 for different logic states stored by the material of the memory cell 605 (e.g., a difference between threshold voltages when the material is storing a logic state '0' versus a logic state '1') may correspond to the read window of the memory cell 605.

In a read operation, a memory cell 605 may be read from by applying a read bias (e.g., where V_{access} = V_{read}, which may be a positive voltage or a negative voltage) across the memory cell 605. In some examples, a logic state of the memory cell 605 may be evaluated based on whether the memory cell 605 thresholds (e.g., transitions to a relatively lower-resistance or conductive state, permits current) in the presence of the applied read bias. For example, such a read bias may cause a memory cell 605 storing a first logic state (e.g., a logic 0) to threshold (e.g., permit a current flow, permit a current above a threshold current), and may not cause a memory cell 605 storing a second logic state (e.g., a logic 1) to threshold (e.g., may not permit a current flow, may permit a current below a threshold current).

The memory array 700 may be an example of the electronic device, as described herein with reference to FIGs. 1 through 6. For example, the techniques disclosed herein describe precursors capable of being used in ALD to produce one or more layers of carbon with the purity above the threshold amount for the memory array 700. For instance, the techniques may include exposing a material (e.g., a base material) to a first precursor and reacting the first precursor with the material to form a first carbon compound, where the first precursor may include at least one of germanium, silicon, or tin. Additionally, the techniques may include reacting a second, carbon-containing precursor with the carbon compound to form a layer of carbon on the material.

Information and signals described herein may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof. Some drawings may illustrate signals as a single signal; however, the signal may represent a bus of signals, where the bus may have a variety of bit widths.

As used herein, the singular forms "a," "an," and "the" are intended to include the plural forms as well, unless the context clearly indicates otherwise.

As used herein, "and/or" includes any and all combinations of one or more of the associated listed items.

As used herein, the term "substantially" in reference to a given parameter, property, or condition means and includes to a degree that one of ordinary skill in the art would understand that the given parameter, property, or condition is met with a degree of variance, such as within acceptable manufacturing tolerances. By way of example, depending on the particular parameter, property, or condition that is substantially met, the parameter, property, or condition may be at least 90.0% met, at least 95.0% met, at least 99% met, or at least 99.9% met.

As used herein, spatially relative terms, such as "adjacent," "beneath," "below," "lower," "bottom," "above," "upper," "top," "front," "rear," "left," "right," and the like, may be used for ease of description to describe one element's or feature's relationship to another element (s) or feature(s) as illustrated in the figures. Unless otherwise specified, the spatially relative terms are intended to encompass different orientations of the materials in addition to the orientation depicted in the figures. For example, if materials in the figures are inverted, elements described as "below" or "beneath" or "under" or "on bottom of" other elements or features would then be oriented "above" or "on top of" the other elements or features. Thus, the term "below" can encompass both an orientation of above and below, depending on the context in which the term is used, which will be evident to one or ordinary skill in the art. The materials may be otherwise oriented (e.g., rotated 90 degrees, inverted, flipped), and the spatially relative descriptors used herein interpreted accordingly.

As used herein, the term "electronic device" may include, without limitation, a memory device, as well as semiconductor devices, which may or may not incorporate memory, such as a logic device, a processor device, or a radiofrequency (RF) device. Further, an electronic device may incorporate memory in addition to other functions such as, for example, a so-called "system on a chip" (SoC) including a processor and memory, or an electronic device including logic and memory. The electronic device may be a 3D electronic device, such as a 3D dynamic random access memory (DRAM) memory device, a 3D crosspoint memory device, or a 3D phase-change random access memory (PCRAM) memory device.

As used herein, the term "substrate" means and includes a foundation material or construction upon which components, such as those within a semiconductor device or electronic device are formed. The substrate may be a semiconductor substrate, a base material, a base semiconductor material on a supporting structure, a metal electrode, or a semiconductor substrate having one or more materials, structures, or regions formed thereon. The substrate may be a conventional silicon substrate, or other bulk substrate including a semiconductive material. As used herein, the term "bulk substrate" means and includes not only silicon wafers, but also silicon-on insulator ("SOI") substrates, such as silicon-on-sapphire ("SOS") substrates or silicon-on-glass ("SOG") substrates, epitaxial layers of silicon on a base semiconductor foundation, or other semiconductor or optoelectronic materials, such as silicon-germanium (Si₁₋ₓGeₓ, where x is, for example, a mole fraction between 0.2 and 0.8), germanium (Ge), gallium arsenide (GaAs), gallium nitride (GaN), or indium phosphide (InP), among others. Furthermore, when reference is made to a "substrate" in the following description, previous process stages may have been utilized to form materials, regions, or junctions in or on the base semiconductor structure or foundation.

The terms "layer" and "level" used herein refer to an organization (e.g., a stratum, a sheet) of a geometrical structure (e.g., relative to a substrate). Each layer or level may have three dimensions (e.g., height, width, and depth) and may cover at least a portion of a surface. For example, a layer or level may be a three dimensional structure where two dimensions are greater than a third, e.g., a thin-film. Layers or levels may include different elements, components, or materials. In some examples, one layer or level may be composed of two or more sublayers or sublevels.

As used herein, the term "electrode" may refer to an electrical conductor, and in some examples, may be employed as an electrical contact to a memory cell or other component of a memory array. An electrode may include a trace, a wire, a conductive line, a conductive layer, or the like that provides a conductive path between components of a memory array.

The devices discussed herein, including a memory array, may be formed on a semiconductor substrate, such as silicon, germanium, silicon-germanium alloy, gallium arsenide, gallium nitride, etc. In some examples, the substrate is a semiconductor wafer. In other examples, the substrate may be a silicon-on-insulator (SOI) substrate, such as silicon-on-glass (SOG) or silicon-on-sapphire (SOP), or epitaxial layers of semiconductor materials on another substrate. The conductivity of the substrate, or sub-regions of the substrate, may be controlled through doping using various chemical species including, but not limited to, phosphorous, boron, or arsenic. Doping may be performed during the initial formation or growth of the substrate, by ion-implantation, or by any other doping means.

The description set forth herein, in connection with the appended drawings, describes example configurations and does not represent all the examples that may be implemented or that are within the scope of the claims. The term "exemplary" used herein means "serving as an example, instance, or illustration," and not "preferred" or "advantageous over other examples." The detailed description includes specific details to provide an understanding of the described techniques. These techniques, however, may be practiced without these specific details. In some instances, well-known structures and devices are shown in block diagram form to avoid obscuring the concepts of the described examples.

In the appended figures, similar components or features may have the same reference label. Further, various components of the same type may be distinguished by following the reference label by a dash and a second label that distinguishes among the similar components. If just the first reference label is used in the specification, the description is applicable to any one of the similar components having the same first reference label irrespective of the second reference label.

The functions described herein may be implemented in hardware, software executed by a processor, firmware, or any combination thereof. If implemented in software executed by a processor, the functions may be stored on or transmitted over as one or more instructions (e.g., code) on a computer-readable medium. Other examples and implementations are within the scope of the disclosure and appended claims. For example, due to the nature of software, functions described herein can be implemented using software executed by a processor, hardware, firmware, hardwiring, or combinations of any of these. Features implementing functions may also be physically located at various positions, including being distributed such that portions of functions are implemented at different physical locations.

For example, the various illustrative blocks and modules described in connection with the disclosure herein may be implemented or performed with a processor, such as a DSP, an ASIC, an FPGA, discrete gate logic, discrete transistor logic, discrete hardware components, other programmable logic device, or any combination thereof designed to perform the functions described herein. A processor may be an example of a microprocessor, a controller, a microcontroller, a state machine, or any type of processor. A processor may also be implemented as a combination of computing devices (e.g., a combination of a DSP and a microprocessor, multiple microprocessors, one or more microprocessors in conjunction with a DSP core, or any other such configuration).

As used herein, including in the claims, "or" as used in a list of items (for example, a list of items prefaced by a phrase such as "at least one of" or "one or more of") indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

Computer-readable media includes both non-transitory computer storage media and communication media including any medium that facilitates transfer of a computer program from one place to another. A non-transitory storage medium may be any available medium that can be accessed by a computer. By way of example, and not limitation, non-transitory computer-readable media can comprise RAM, ROM, electrically erasable programmable read-only memory (EEPROM), compact disk (CD) ROM or other optical disk storage, magnetic disk storage or other magnetic storage devices, or any other non-transitory medium that can be used to carry or store desired program code means in the form of instructions or data structures and that can be accessed by a computer, or a processor. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, digital subscriber line (DSL), or wireless technologies such as infrared, radio, and microwave are included in the definition of medium. Disk and disc, as used herein, include CD, laser disc, optical disc, digital versatile disc (DVD), floppy disk and Blu-ray disc where disks usually reproduce data magnetically, while discs reproduce data optically with lasers. Combinations of the above are also included within the scope of computer-readable media.

The description herein is provided to enable a person skilled in the art to make or use the disclosure. Various modifications to the disclosure will be apparent to those skilled in the art, and the generic principles defined herein may be applied to other variations without departing from the scope of the disclosure. Thus, the disclosure is not limited to the examples and designs described herein but is to be accorded the broadest scope consistent with the principles and novel features disclosed herein.

## Claims

1. A method, comprising:
forming a plurality of stacks of materials on a substrate;
exposing the plurality of stacks of materials to a first precursor to form a carbon compound on the plurality of stacks of materials, wherein the first precursor comprises at least one of germanium, silicon, or tin; and
exposing the plurality of stacks to a second, carbon-containing precursor to form layer of carbon on the plurality of stacks of materials.

2. The method of claim 1, wherein the first precursor comprises a chemical formula R1R2R3A-ZR4R5R6, wherein A or Z are independently selected from the germanium, the tin, the silicon, or a lead.

3. The method of claim 1, wherein the first precursor comprises a chemical formula R1R2R3A-ZR4R5R6, wherein each of R1, R2, R3, R4, R5, and R6 are independently selected from hydrogen, an alkyl group, an alkoxy, a di-alkylamide, an alkyl-sulfide, an alkyl-selenide, a halide, or an alkyl-telluride.

4. The method of claim 1, wherein the first precursor comprises a chemical formula R1R2R3A-ZR4R5R6, wherein A or Z are the silicon, and wherein each of R1, R2, R3, R4, R5, and R6 are an alkyl group.

5. The method of any preceding claim, wherein the second, carbon-containing precursor comprises a chemical formula CX1X2X3X4, wherein each of X1, X2, X3, and X4 are independently selected from a fluorine, a chlorine, a bromine, an iodine, a methoxy, an ethoxy, an alkoxy, a sulfoxy, a selenoxy, a telluroxy, a dimethylamino, a diethylamino, an ethylmethylamino, a di-alkylamino, a hydrogen, or any combination thereof.

6. The method of any of claims 1 to 4, wherein the second, carbon-containing precursor comprises a chemical formula CX1X2X3X4, wherein each of X1, X2, X3, and X4 are a bromine.

7. The method of any preceding claim, wherein exposing the plurality of stacks of material to the first precursor or exposing the plurality of stacks of material to the second, carbon-containing precursor to form the layer of carbon comprises conducting the exposing at a temperature at or below 400°C.

8. The method of claim 7, wherein the temperature is at or below 300°C.

9. An apparatus, comprising:
a plurality of stacks of materials on a substrate, at least one material of the plurality of stacks of materials comprising a memory material; and
a layer of carbon on the plurality of stacks of materials formed by exposing the plurality of stacks of materials to a first precursor comprising at least one of germanium, silicon, or tin and by exposing the plurality of stacks of materials to a second, carbon-containing precursor.

10. The apparatus of claim 9, wherein the first precursor comprises a chemical formula R1R2R3A-ZR4R5R6, wherein A or Z are independently selected from the germanium, the tin, the silicon, or a lead.

11. The apparatus of claim 9, wherein the first precursor comprises a chemical formula R1R2R3A-ZR4R5R6, wherein each of R1, R2, R3, R4, R5, and R6 are independently selected from hydrogen, an alkyl group, an alkoxy, a di-alkylamide, an alkyl-sulfide, an alkyl-selenide, a halide, or an alkyl-telluride.

12. The apparatus of claim 9, wherein the first precursor comprises a chemical formula R1R2R3A-ZR4R5R6, wherein A or Z are the silicon, and wherein each of R1, R2, R3, R4, R5, and R6 are an alkyl group.

13. The apparatus of any of claims 9 to 12, wherein the second, carbon-containing precursor comprises a chemical formula CX1X2X3X4, wherein each of X1, X2, X3, and X4 are independently selected from a fluorine, a chlorine, a bromine, an iodine, a methoxy, an ethoxy, an alkoxy, a sulfoxy, a selenoxy, a telluroxy, a dimethylamino, a diethylamino, an ethylmethylamino, a di-alkylamino, a hydrogen, or any combination thereof.

14. The apparatus of any of claims 9 to 12, wherein the second, carbon-containing precursor comprises a chemical formula CX1X2X3X4, wherein each of X1, X2, X3, and X4 are a bromine.

15. The apparatus of any of claims 9 to 14, wherein the exposing of the plurality of stacks of material to the first precursor or the exposing the plurality of stacks of material to the second, carbon-containing precursor to form the layer of carbon is performed at a temperature at or below 400°C.
